(19) **Europäisches Patentamt**

**European Patent Office**

**Office européen des brevets**

(11) **EP 0 660 334 B1**

(12) **EUROPÄISCHE PATENTSCHRIFT**

(45) Veröffentlichungstag und Bekanntmachung des Hinweises auf die Patenterteilung:
**20.03.2002 Patentblatt 2002/12**

(51) Int Cl.⁷: **G11C 27/00**, G11C 11/56, G11C 7/00

(21) Anmeldenummer: **94119205.6**

(22) Anmeldetag: **06.12.1994**

(54) **Schaltungsanordnung zur Speicherung von digitalen Audiosignalen**

Circuit arrangement for storage of digital audio signals

Circuit pour la mémorisation de signaux audio numériques

(84) Benannte Vertragsstaaten:
**AT DE ES FR IT**

(30) Priorität: **24.12.1993 DE 4344528**

(43) Veröffentlichungstag der Anmeldung:
**28.06.1995 Patentblatt 1995/26**

(73) Patentinhaber: **Blaupunkt-Werke GmbH**
**31132 Hildesheim (DE)**

(72) Erfinder: **Kaesser, Jürgen, Dr.**
**D-31199 Diekholzen (DE)**

(56) Entgegenhaltungen:
**EP-A- 0 523 519**          **WO-A-93/22770**

• **ELEKTRONIK PRAXIS, Bd. 19, Nr. 7, Oktober 1993, DE, Seiten 38-40, XP002026885 "Nichtflüchtig Analogsignale speichern"**

**Beschreibung**

Die Erfindung geht aus von einer Schaltungsanordnung nach der Gattung des Hauptanspruchs.

Audiosignale werden für verschiedene Zwecke in digitaler Form gespeichert - beispielsweise bei Anrufbeantwortern, elektronischen Notizbüchern, in Autoradios zur Speicherung von Verkehrsmeldungen und als Sprachausgabe bei einer Reihe von elektronischen Geräten. Zur Speicherung der digitalen Audiosignale wird dabei realativ viel Speicherplatz benötigt, insbesondere wenn längere Texte gespeichert werden sollen.

Es ist ferner die Sprachspeicherung mit Hilfe von Analogspeichern bekanntgeworden (ELEKTRONIKPRAXIS, Nr 19, 17.10.93, Seiten 38 bis 41). Diese Analogspeicher werden in Form von elektrisch löschbaren Nur-Lesespeichern ($E^2$ PROM) angeboten und ermöglichen die Speicherung von bis zu 128000 Abtastwerten, was bei einer Telefonqualität der Audiosignale einer Wiedergabedauer von 1 Minute entspricht.

Aufgabe der vorliegenden Erfindung ist es, bei der Speicherung und/oder Wiedergabe von Audiosignalen den Bedarf an Speichern, das heißt an Siliziumfläche, weiter zu verringern.

Diese Aufgabe wird mit dem im kennzeichnenden Teil des Patentanspruchs 1 angegebenen Merkmalen gelöst. Außer dem Vorteil des geringen Speicherbedarfs ist die erfindungsgemäße Schaltungsanordnung besonders vorteilhaft bei denjenigen Anwendungen, bei denen die Audiosignale bereits in digitaler Form vorliegen.

Eine weitere Verminderung des Speicherbedarfs ist gemäß einer Weiterbildung der Erfindung dadurch möglich, daß mehrere digitale Abtastwerte der datenreduzierten digitalen Signale jeweils ein Datenwort bilden, das in Form eines Analogwertes in einer Zelle des Analogspeichers abgelegt wird.

Diese Weiterbildung ist insbesondere dann vorteilhaft, wenn der jeweils verwendete Analogspeicher eine Genauigkeit hat, welche größer als diejenige der datenreduzierten Signale ist.

Um dabei eine möglichst geringe Fehlerrate zu erzielen, ist es günstig, wenn bei der Bildung eines Datenwortes die Bits der beteiligten Abtastwerte derart verschachtelt werden, daß im Datenwort die Bits nach ihrer Wertigkeit in den beteiligten Abtastwerten geordnet sind.

Eine zufriedenstellende Qualität für Zwecke einer Sprachausgabe bei geringem Speicherbedarf ergibt sich gemäß einer Ausgestaltung der Erfindung dadurch, daß eine Datenreduktion der zu speichernden Audiosignale zu vier Bit je Abtastwert erfolgt und daß jeweils zwei Abtastwerte in einer Zelle des Analogspeichers abgelegt werden.

Eine Ausführungsform der Erfindung ist für Nurwiedergabeanwendungen geeignet und besteht darin, daß die Audiosignale in einem nichtflüchtigen Analogspeicher gespeichert sind, wobei jeweils ein in einer Speicherzelle vorhandener Analogwert Informationen aus mehreren Abtastwerten der Audiosignale enthält, daß aus dem Analogspeicher ausgelesene Analogwerte in digitale Datenwörter umgewandelt werden und daß aus jeweils einem Datenwert mehrere Abtastwerte der wiederzugebenden Audiosignale abgeleitet werden.

Für die erfindungsgemäße Schaltungsanordnung ist als Analogspeicher ein Festkörperspeicher, vorzugsweise ein elektrisch löschbarer programmierbarer Nur-Lese-Speicher ($E^2$ PROM), geeignet.

Eine andere Weiterbildung der Erfindung besteht darin, daß die Analogwerte derart normiert sind, daß die Differenz zwischen dem kleinsten und dem größten aus einem Datenwort ableitbaren Analogwert dem Amplitudenbereich des Analogspeichers entspricht. Dadurch ist eine optimale Ausnutzung des Amplitudenbereichs des Analogspeichers möglich.

Ausführungsbeispiele der Erfindung sind in der Zeichnung anhand mehrerer Figuren dargestellt und in der nachfolgenden Beschreibung näher erläutert. Es zeigt:

Fig. 1    ein Blockschaltbild einer erfindungsgemäßen Schaltungsanordnung und

Fig. 2    ein etwas detaillierter dargestelltes Blockschaltbild.

Gleiche Teile sind in den Figuren mit gleichen Bezugszeichen versehen.

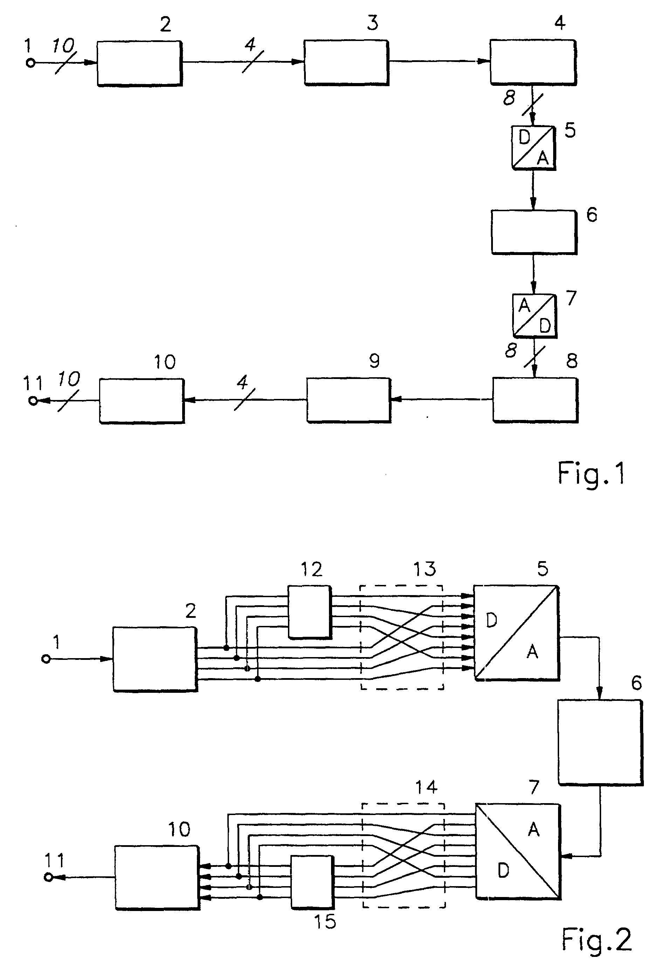

Der in Fig. 1 dargestellten Schaltungsanordnung werden bei 1 digitale Audiosignale zugeführt, beispielsweise in einem 10 Bit breiten Datenstrom. Bei 2 erfolgt zunächst eine Datenreduktion auf vier Bit pro Abtastwert durch ein geeignetes Datenreduktionsverfahren, beispielsweise ADPCM oder LPC.

Zur weiteren Verarbeitung werden die datenreduzierten digitalen Signale in einen Zwischenspeicher 3 eingeschrieben und je nach Bedarf in der folgenden Schaltung ausgelesen. Bei 4 erfolgt eine Bitverschachtelung derart, daß jeweils mehrere digitale Abtastwerte zu einem Datenwort zusammengefaßt werden. Im Digital/Analog-Wandler 5 wird eine dem Digitalwert des Datenwortes zugeordnete Ladungsmenge erzeugt und im Analog-$E^2$PROM 6 abgelegt.

Zur Wiedergabe der im Analog-$E^2$PROM 6 gespeicherten Audiosignale werden diese aus dem Analog- $E^2$PROM 6 ausgelesen und einem Analog/Digital-Wandler 7 zugeführt. Die Ausgangssignale des Analog/Digital-Wandlers -Wandlers 7 enthalten pro Datenwort jeweils mehrere Abtastwerte, die in einer Schaltung 8 wieder in mehrere aufeinanderfolgende Datenworte aufgespalten werden. Diese werden über einen Zwischenspeicher 9 einer Schaltung 10 zur Sprachgenerierung zugeführt, an deren Ausgang 11 ein die Audiosignale darstellender 10 Bit breiter Datenstrom anliegt.

Bei dem in Fig. 2 dargestellten Ausführungsbeispiel sind die Schaltungen 3, 4, 8 und 9 des Ausführungsbeispiels nach Fig. 1 etwas detaillierter dargestellt. Von den vier Bit breiten Ausgangssignalen der Schaltung 2 zur Datenreduktion wird jeder zweite Abtastwert mit einem Zwischenspeicher 12 für eine Abtastperiode zwischengespeichert, so daß an den Eingängen des Digital/Analog-Wandlers 5 die Bits jeweils zweier Abtastwerte gleichzeitig anliegen. Bei einer Bitbreite der Abtastwerte von vier liegen acht Bit an den Eingängen des Digital/Analog-Wandlers 5 an. Diese werden bei 13 derart miteinander verschachtelt, daß die Reihenfolge der Wertigkeit erhalten bleibt.

Die beiden höchstwertigen Bits des Eingangssignals des Digital/Analog-Wandlers 5 werden also von beiden höchstwertigen Bits der beiden zu verschachtelnden Abtastwerte gebildet. Das gleiche gilt für die Bits mit geringerer Wertigkeit. Dadurch wird erreicht, daß die höchstwertigen Bits beider Abtastwerte etwa die gleiche Sicherheit haben und auch die weniger bedeutenden Bits möglichst gleichwertig belegt werden. Bei der in dem Ausführungsbeispiel nach Fig. 2 gewählten Lösung mit zwei Abtastwerten mit jeweils vier Bits und einer Genauigkeit des Speichers von acht Bit können die beiden Abtastwerte als Analogwerte wie folgt angegeben werden:

$$x_1 = \sum_{n=0}^{3} a_n^{(1)} \cdot 2^{-n}, \qquad x_2 = \sum_{n=0}^{3} a_n^{(2)} \cdot 2^{-n},$$

Die abzuspeichernde Spannung ergibt sich dann in der Form:

$$y = \sum_{n=0}^{3} a_n^{(1)} \cdot 2^{-(2n+1)} + \sum_{n=0}^{3} a_n^{(2)} \cdot 2^{-2n}$$

Dabei ist n die Nummer des jeweiligen Bits innerhalb eines Abtastwertes und a ein Wert, der in Abhängigkeit vom jeweiligen Bit entweder 0 oder eine vorgegebene Spannung sein kann.

Um den Spannungsbereich der Speicherzellen voll auszunutzen, kann eine Normierung der Spannung mit $1/(1-2^{-4}) = 1,06$ erfolgen.

Sind Analogspeicher mit einer entsprechenden Genauigkeit verfügbar, so können auch mehr als zwei Abtastwerte innerhalb einer Speicherzelle gespeichert werden. Für eine beliebige Anzahl z von Werten mit jeweils N Bit und einer Genauigkeit des Speichers von M Bit, wobei $z \cdot N = M$ gelten sollte, kann die zu speichernde Spannung wie folgt berechnet werden:

$$y = \sum_{n=0}^{N-1} \sum_{m=1}^{z} a_n^{(m)} \cdot 2^{-(nz+m-1)},$$

wobei im Falle einer Normierung für die einzuschreibende Spannung gilt:

$$U = y/(1-2^{-M})$$

Nach dem Auslesen der einzelnen Analogwerte aus dem Speicher 6 und Erzeugung von acht Bit breiten Datenworten am Ausgang des Analog/Digital-Wandlers 7 werden die Bits dieser Datenworte wieder in einzelne Abtastwerte von jeweils vier Bit aufgespalten, was durch die Leitungsführung bei 14 (Fig. 2) verdeutlicht ist. Nach Verzögerung der Bits eines jeden zweiten Abtastwertes bei 15 werden die dann vier Bit breiten Signale wie bei der Schaltungsanordnung nach Fig. 1 einer Schaltung 10 zur Sprachgenerierung zugeführt, an deren Ausgang 11 die wiedergegebenen Audiosignale abgenommen werden können.

**Patentansprüche**

1. Schaltungsanordnung zur Speicherung von digitalen Audiosignalen, insbesondere digitalen Sprachsignalen, mit einem Analogspeicher (6), dem die zu speichernden Audiosignale nach einer Digital/Analog-Wandlung als Analogwerte zuführbar sind,
   **dadurch gekennzeichnet,**
   **daß** die digitalen Audiosignale einer Datenreduktion zugeführt sind,
   und **daß** mehrere digitale Abtastwerte der datenreduzierten digitalen Audiosignale ein Datenwort bilden, das in Form eines Analogwertes in einer Zelle des Analogspeichers (6) abgelegt wird.

2. Schaltungsanordnung nach Anspruch 1, **dadurch gekennzeichnet, daß** bei der Bildung eines Datenworts die Bits der beteiligten Abtastwerte derart verschachtelt werden, daß im Datenwort die Bits nach ihrer Wertigkeit in den beteiligten Abtastwerten geordnet sind.

3. Schaltungsanordnung nach Anspruch 1 oder 2, **dadurch gekennzeichnet, daß** eine Datenreduktion der zu speichernden Audiosignale zu vier Bit je Abtastwert erfolgt, und daß jeweils zwei Abtastwerte in einer Zelle des Analogspeichers (6) abgelegt werden.

4. Schaltungsanordnung nach einem der vorhergehenden Ansprüche, **dadurch gekennzeichnet, daß** der Analogspeicher (6) ein Festkörperspeicher ist.

5. Schaltungsanordnung nach Anspruch 4, **dadurch gekennzeichnet, daß** der Analogspeicher (6) ein elektrisch löschbarer programmierbarer Nur-Lese-Speicher ($E^2$PROM) ist.

6. Schaltungsanordnung nach einem der vorhergehenden Ansprüche, **dadurch gekennzeichnet, daß** die Analogwerte derart normiert sind, daß die Differenz zwischen dem kleinsten und dem größten aus einem Datenwort ableitbaren Analogwert dem Amplitudenbereich des Analogspeichers (6) entspricht.

7. Schaltungsanordnung zur Wiedergabe von Audiosignalen, die in einem nichtflüchtigen Analogspeicher (6) gespeichert sind,
   wobei aus dem Speicher ausgelesene Analogwerte einer Analog/Digital-Wandlung (7) zur Wandlung in digitale Datenwörter zugeführt werden,
   **dadurch gekennzeichnet, daß**
   jeweils ein in einer Speicherzelle des Analogspeichers (6) vorhandener Analogwert Informationen aus mehreren Abtastwerten eines Audiosignals enthält,
   und wobei aus jeweils einem Datenwort mehrere Abtastwerte des wiederzugebenden Audiosignals abgeleitet werden.

**Claims**

1. Circuit arrangement for storing digital audio signals, in particular digital voice signals, having an analogue memory (6) to which the audio signals which are to be stored can be supplied as analogue values after digital/analogue conversion,
   **characterized**
   **in that** the digital audio signals are supplied to a data reduction stage,
   and **in that** a plurality of digital samples of the reduced-data digital audio signals form a data word which is stored in the form of an analogue value in a cell of the analogue memory (6).

2. Circuit arrangement according to Claim 1,
   **characterized in that**, when a data word is formed, the bits of the samples involved are interleaved such that the bits in the data word are organized according to their significance in the samples involved.

3. Circuit arrangement according to Claim 1 or 2,
   **characterized in that** data reduction for the audio signals which are to be stored is effected to the degree of four bits per sample, and **in that** two samples are stored in a cell of the analogue memory (6) in each case.

4. Circuit arrangement according to one of the preceding claims, **characterized in that** the analogue memory (6) is a solid-state memory.

**5.** Circuit arrangement according to Claim 4,
**characterized in that** the analogue memory (6) is an electrically erasable programmable read-only memory (E$^2$PROM).

**6.** Circuit arrangement according to one of the preceding claims, **characterized in that** the analogue values are normalized such that the difference between the smallest and the largest analogue value which can be derived from a data word corresponds to the amplitude range of the analogue memory (6).

**7.** Circuit arrangement for reproducing audio signals stored in a non-volatile analogue memory (6), with analogue values read from the memory being supplied to an analogue/digital conversion stage (7) for conversion into digital data words,
**characterized in that** a respective analogue value present in a memory cell of the analogue memory (6) contains information comprising a plurality of samples of an audio signal,
and where a plurality of samples of the audio signal which is to be reproduced are derived from a respective data word.


**Revendications**

**1.** Circuit de mémorisation de signaux audio numériques notamment de signaux vocaux numérisés comprenant une mémoire analogique (6) à laquelle on applique les signaux audio à mémoriser après une conversion numérique/analogique, sous la forme de valeurs analogiques,
**caractérisé en ce que**
les signaux audio numériques subissent une réduction de données, et plusieurs valeurs de détection numériques des signaux audio numériques, dont les données ont été réduites, forment un mot de données enregistré comme valeur analogique dans une cellule de la mémoire analogique (6).

**2.** Circuit selon la revendication 1,
**caractérisé en ce qu'**
en formant un mot de données on imbrique les bits des valeurs de détection correspondantes pour que dans le mot de données, les bits soient organisés suivant leur valeur dans les valeurs de détection concernées.

**3.** Circuit selon l'une quelconque des revendications 1 ou 2,
**caractérisé en ce qu'**

on effectue une réduction des données des signaux audio à mémoriser sur quatre bits par valeur de détection, et
on enregistre chaque fois deux valeurs de détection dans une cellule de la mémoire analogique (6).

**4.** Circuit selon l'une quelconque des revendications précédentes,
**caractérisé en ce que**
la mémoire analogique (6) est une mémoire solide.

**5.** Circuit selon la revendication 4,
**caractérisé en ce que**
la mémoire analogique (6) est une mémoire morte, programmable pouvant être effacée électriquement (E$^2$PROM).

**6.** Circuit selon l'une quelconque des revendications précédentes,
**caractérisé en ce que**
les valeurs analogiques sont normées pour que la différence entre la valeur analogique la plus petite et la plus grande que l'on peut déduire d'un mot de données correspondent à la plage d'amplitudes de la mémoire analogique (6).

**7.** Circuit de reproduction de signaux audio mémorisés dans une mémoire analogique (6) non volatile,
les valeurs analogiques lues dans la mémoire étant appliquées à une conversion analogique/numérique (7) pour les transformer en mots de données numériques,

**caractérisé en ce que**

chaque fois une valeur analogique existant dans une cellule de mémoire de la mémoire analogique (6), contient des informations de plusieurs valeurs de détection d'un signal audio,
et à partir de chaque mot de données on peut déduire plusieurs valeurs de détection du signal audio à reproduire.

Fig.1

Fig.2

7